# EUROPEAN PATENT SPECIFICATION

(11) **EP 0 867 999 B1**
(45) Date of publication and mention of the grant of the patent: **28.11.2007**
(21) Application number: 98103553.8
(22) Date of filing: 28.02.1998
(51) Int. Cl.: H02H 7/12

(54) **A method and a device for detecting and handling short-circuit phenomena for power semiconductor devices**
Verfahren und Vorrichtung zum Erfassen und Behandeln von Kurzschlussphänomenen für Leistungshalbleiterelemente
Procédé et dispositif pour la détection et traitement des phénomènes de court-circuit pour des dispositifs semi-conducteur de puissance

(30) Priority: 24.03.1997 SE 9701057
(43) Date of publication of application: 30.09.1998
(73) Proprietor: ABB AB, 721 83 Västerås (SE)
(72) Inventor: Bijlenga, Bo, 730 50 Skultuna (SE); Lundberg, Peter, 722 23 Västerås (SE)
(74) Representative: Olsson, Jan

(56) References cited:
- DE-A- 4 218 749
- SE-B- 419 149
- US-A- 4 084 206
- PATENT ABSTRACTS OF JAPAN vol. 009, no. 143 (E-322), 18 June 1985 & JP 60 026460 A (HITACHI SEISAKUSHO KK), 9 February 1985,
- PATENT ABSTRACTS OF JAPAN vol. 009, no. 131 (E-319), 6 June 1985 & JP 60 016171 A (HITACHI SEISAKUSHO KK), 26 January 1985,

## Description

### FIELD OF THE INVENTION AND PRIOR ART

The present invention relates to a method for handling a short-circuit situation occurring in a circuit having a plurality of power semiconductor devices of turn-off type connected in series after detecting thereof and a device for handling such a situation according to the preambles of appended claims 1 and 8, respectively.

Such circuits having power semiconductor devices connected in series may for example be used in voltage-stiff converters in stations of plants for transmitting electric power through High Voltage Direct Current (HVDC) or for reactive power compensation (RPC) for converting direct voltage to alternating voltage and conversely. These converters may in such plants typically have to hold voltages within the range 10-500 kV, although also other voltages are conceivable, which makes it possible to connect comparatively many such power semiconductor devices in series so as to distribute the voltage among them, since they normally each may only hold 1-5 kV. However, it is emphasized that the invention is not in any way restricted to such so-called high voltage converter circuits, even though this special application will be described hereinafter for illuminating the problem upon which the present invention is based.

Examples of such power semiconductor devices of turn-off type are turn-off thyristors (GTO), MOSFETs and IGBTs (Insulated Gate Bipolar Transistor), wherein the latter ones are to prefer in many respects, since they combine a good power handling ability with properties making them well suited for connection in series in so-called IGBT valves in converters, since they may be turned on and turned off simultaneously with a high accuracy.

Short-circuit situations may in rare cases occur in these circuits, and it is then necessary to be able to handle these in such a way that not entire IGBT valves break down. Such short-circuits may in said application arise for example through any fault of the control apparatus controlling the power semiconductor devices, which may mean that the so-called DC capacitor normally located on the direct voltage side of said station is discharged, so that the short-circuit current will flow through one of the phase legs of the converter. A phase leg is formed by two IGBT valves such a converter has in the same direction. Another possibility to short-circuit is that a short-circuit between a phase terminal and one of the terminals of the DC capacitor occurs or that a short-circuit between two phase terminals occurs, or that a ground fault occurs in a phase terminal and that the DC capacitor is formed by two capacitors having a grounded midpoint.

If a short-circuit occurs in a phase leg provided with IGBT valves the following happens: The individual IGBTs take such a voltage that the short-circuit current is limited to a value being normally 3-10 higher than the nominal current through the IGBT valves under normal operation. The IGBTs make this thanks to a current-limiting IV characteristics thereof, just as other transistors. During the current-limiting process the power semiconductor devices are exerted to a very high power dissipation, which they may only stand during a very restricted period of time, typically 10 µs.

Thus, when such a short-circuit occurs there is a desire to be able to turn off the different power semiconductor devices as soon as possible so as to prevent breakdown of any of them. However, there is a problem because of variations of the drive units controlling each individual power semiconductor device, which means differently fast turn-off, individual variations between the different power semiconductor devices so that they take differently much voltage during the current-limiting process and are turned off differently fast as well as other individual variations therebetween, which results in considerable problems during the current-limiting process as well as at turn-off when a short-circuit occurs. It is namely so that during both the current-limiting process and during the turn-off process the entire series connection of the power semiconductor devices has to take a certain voltage, in which the voltage to be taken by a certain power semiconductor device may through said variations be too high, while it may be considerably lower and completely acceptable across other power semiconductor devices. This means a high risk of failure of any power semiconductor device, this may for example happen when the voltage across a power semiconductor device gets so high that the high field strength generated thereacross leads to "avalanche", which means that nearly all power is concentrated to a certain point. It is also possible that the high voltage in combination with a high short-circuit current leads to a too hot power semiconductor device breaking down as a consequence thereof.

A method and a device according to the introduction are known through DE 42 18 749 A, which discloses a method for handling a short-circuit situation occurring in a circuit having a plurality of power semiconductor devices of turn-off type connected in series after detection thereof as well as a device for such handling through which it is prevented that the voltage across an individual power semiconductor device gets so high that the power semiconductor device arrives above the short-circuit safe operating area for the given gate voltage when the power semiconductor device is in current-limiting mode.

### SUMMARY OF THE INVENTION

It is an object of the present invention to further improve a method and device of the type defined in the introduction so as to among others more reliably remain within said short-circuit safe operating area.

This object is according to the present invention obtained with respect to the method by reducing the turn-off speed of each individual power semiconductor device during the turn-off process when the voltage measured thereacross increases. Such a retardation of the voltage increase of exactly that or those semiconductor devices where this increase is the largest is in this way obtained, which results in a good voltage division and that the instantaneous over-voltage at the turn-off process is reduced and by that the power semiconductor device may be kept within said short-circuit safe operation area.

According to a preferred embodiment of the invention when the voltage measured between the two electrodes of an individual power semiconductor device exceeds a predetermined value it is changed to turning the power semiconductor device on by reversing the direction of said current supply to the gate of this power semiconductor device with respect to the direction during turn-off. It may by turning the power semiconductor device on again in this way be avoided that the voltage across the electrodes thereof rises above the highest allowed level of an individual power semiconductor device.

According to another preferred embodiment of the invention when said short-circuit situation is detected during the turn-on process of an individual power semiconductor device and this by that is in current limiting mode it is during the turn-off process caused by said detection changed to turn the power semiconductor device on when the voltage exceeds a said predetermined value being lower than the upper limit for the short-circuit safe operating area of the power semiconductor device. The advantages thereof appear from the above.

According to another preferred embodiment of the invention for each individual power semiconductor device a leakage current is fed from the gate with a substantially constant current intensity as long as the voltage measured across the two electrodes of the power semiconductor device is below a predetermined value, and when this value of the voltage is exceeded the intensity of the leakage current is reduced for a slower turn-off of the power semiconductor device. It is by this obtained that the voltage of each individual power semiconductor device does not rise to levels being not permitted.

According to two preferred embodiments of the invention, which are further developments of the embodiment last mentioned, said reduction is achieved by a stepwise or a linear reduction of the intensity of the leakage current when the voltage across the electrodes of the power semiconductor device increases.

According to another preferred embodiment of the invention when a short-circuit situation of one of the power semiconductor devices is detected, said turn-off process for this individual power semiconductor device is immediately started and a signal informing about said detection is sent to an apparatus in common to the power semiconductor devices, whereupon this apparatus sends signals to all the other power semiconductor devices connected in series to start turn-off processes thereof being individually regulated. By this way immediately starting the turn-off process for that power semiconductor device for which the short-circuit is firstly detected the shortest possible reaction time is obtained, which reduces the stress on the power semiconductor devices in the valve.

Preferred embodiments of the device according to the invention make it possible to realise the preferred embodiments mentioned above of the method according to the invention.

### BRIEF DESCRIPTION OF THE DRAWINGS

With reference to the appended drawings, below follows a description of preferred embodiments of the invention cited as examples.

In the drawings:
- Fig 1: is a simplified diagram illustrating a possible circuit having a plurality of power semiconductor devices connected in series, on which the problems according to the invention are applicable,
- Fig 2: is a diagram illustrating how the voltage across the electrodes of an individual power semiconductor device may be measured and how the power semiconductor device may be controlled through a drive unit,
- Fig 3: is a graph illustrating how a short-circuit may be detected according to a method according to the invention,
- Fig 4: is a graph illustrating a comparison of the development of the current through a power semiconductor device after short-circuit on detecting a short-circuit according to prior art and according to a method according to the present invention, and
- Fig 5: is a graph illustrating how the turn-off process of an individual power semiconductor device after detection of a short-circuit may be controlled depending upon the voltage across the electrodes of the power semiconductor device according to a method according to the invention.

### DETAILED DESCRIPTION OF PREFERRED EMBODIMENTS OF THE INVENTION

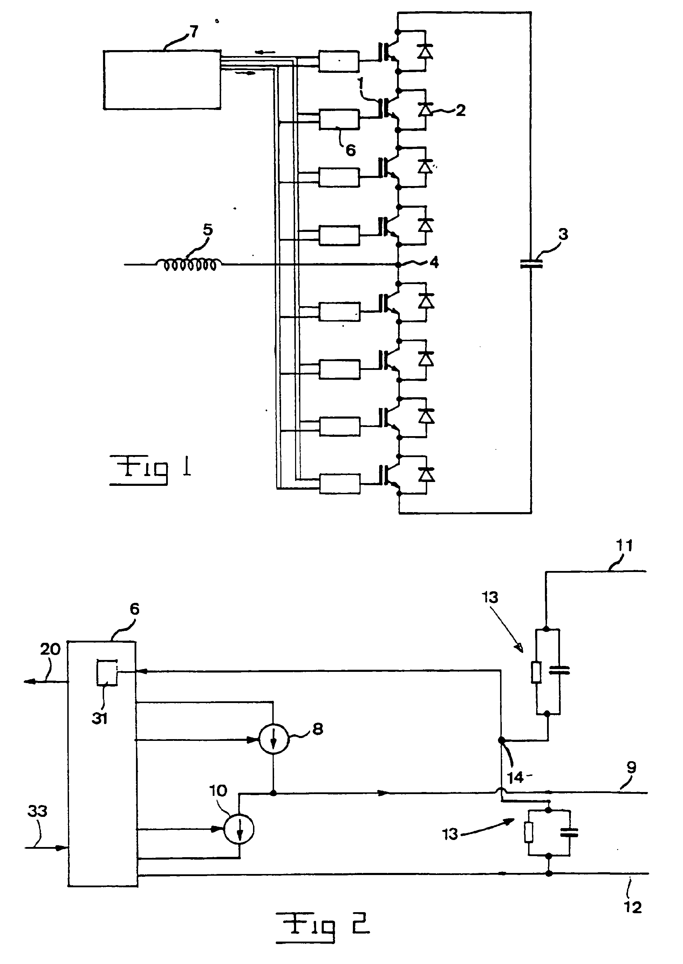

A phase leg of a high voltage converter circuit, on which the present invention is applicable, is schematically shown in Fig 1. There are normally three phase legs having a DC capacitor 3 in common in a plant connected to a three-phase alternating voltage network. This comprises in a conventional way a plurality of power semiconductor devices 1 connected in series, here in the form of IGBTs, and a so-called free-wheeling diode 2 connected in anti-parallel with each such device. The number of power semiconductor devices connected in series is probably in practice considerably higher than shown in Fig 1. The series connection of the power semiconductor devices is connected to a DC capacitor 3, while the phase terminal 4 between the power semiconductor devices is connected to a phase reactor 5 to for example a phase of an alternating voltage network. The power semiconductor devices with diodes arranged above the phase terminal 4 in Fig 1 form in this way an IGBT valve and those located thereunder another IGBT valve, in which all power semiconductor devices in an IGBT valve are turned on simultaneously through signals from a drive unit 6 each schematically indicated, so that the power semiconductor devices in the first IGBT valve are conducting when a positive potential is desired at the phase terminal 4 and the power semiconductor devices in the second IGBT valve are conducting when a negative potential is desired on the phase terminal 4. By controlling the power semiconductor device according to a determined pulse width modulation pattern (PWM) the direct voltage across the DC capacitor 3 may be used for generating a voltage at the phase terminal 4, the fundamental component of which is an alternating voltage having a desired amplitude, frequency and phase position. Such controlling takes place by sending control pulses to the different drive units from a control apparatus 7, which normally takes place through light conductors. A short-circuit may in a converter circuit of this type occur as a consequence of any of the defect situations discussed in the introduction, and it may here be repeated that such a short-circuit may for example take place by a defect of the control of the control apparatus 7, so that the DC capacitor 3 starts to be discharged, in which the current goes in the same direction through all the IGBTs 1. The invention aims at solving the problems arising in such situations in a satisfying way without damaging any power semiconductor devices.

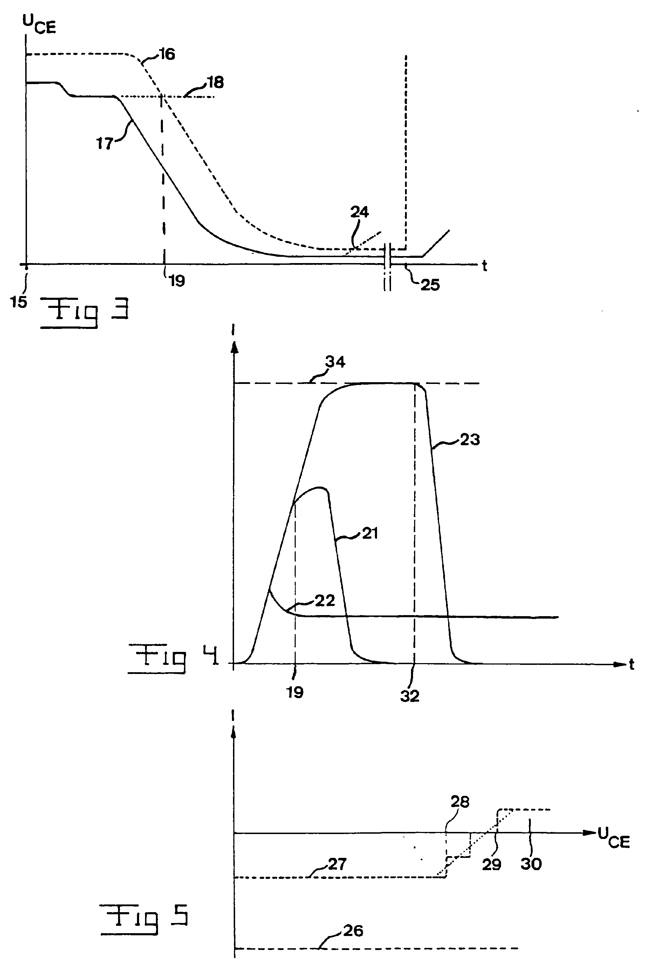

It is shown in Fig 2 how a drive unit 6 for an individual power semiconductor device may connect positive current through a voltage-limited current source 8 to the gate 9 of the power semiconductor device for turning the power semiconductor device on or a negative current to the gate through a second voltage-limited current source 10 for turning the power semiconductor device off. The sources 8 and 10, respectively, may alternatively be two controlled voltage sources in series with a resistor each, which limit the current at turning on and turning off, respectively, to a value appropriate therefor. It is characterizing for the invention that a voltage divider circuit 13 is connected between the collector 11 of the IGBT and the emitter 12 thereof, said circuit being a parallel connection of a resistive and a capacitive voltage divider. Thus, this voltage divider circuit is designed with a wide band width extending from 0 Hz to a frequency region being high with respect to the typical switching frequency of the power semiconductor device, preferably several MHz, so that it may rapidly detect quick transients. It is so designed that a small proportion of the voltage across the collector 11 and the emitter 12 is measured through tapping at the point 14 and supplied to the drive unit 6. By the knowledge of the magnitude of this proportion with respect to the total voltage across the power semiconductor device the voltage last mentioned may in this way be determined.

What is happening when a short-circuit situation occurs, is detected and is handled will now be described with reference to Figs 3-5.

It is illustrated in Fig 3 how a short-circuit is detected in a way according to the invention. The voltage U_{CE} across the two main electrodes of an individual power semiconductor device is shown as a function of the time from the point of time 15 for sending a turn-on order from the control apparatus 7 to the drive unit 6 of the power semiconductor device and further therefrom to the sources 8 and 10 for connecting the former to the gate 9. During the starting process of the turn-on process the power semiconductor device in question is in current-limiting mode and it is important that the voltage thereacross is not increasing to a value being above the upper limit for the safe operating area of the power semiconductor device. A reference voltage value 16 changing with time being higher than the maximum voltage level 17 across the electrodes at normal operation of the power semiconductor device in a given moment is compared in a member 31 with the voltage across the electrodes of the power semiconductor device determined by the voltage divider circuit 13. When the power semiconductor device is turned on into a short circuit the voltage so measured will not as normally is the case sink to the low on-state voltage of the power semiconductor device, but it will continue approximately according to the dashed dotted line 18 and exceed the reference voltage value at a point of time 19. When this takes place a short-circuit is detected by the drive unit 6 and this immediately starts a turn-off process for the power semiconductor device in question by connecting the source 10 to the gate 9 and feed a negative turn-off current to the gate. As indicated through the arrow 20, a signal informing about said detection is simultaneously sent to the control apparatus 7, whereupon this sends signals to all the other power semiconductor devices of the two current valves to start turn-off processes regulated individually so as to turn all the power semiconductor devices connected in series off. The lines 20 and 33 form preferably a fibre optic communication between the drive unit and the control apparatus and different codes may be used so as to indicate for example "short-circuit turn-off", "turn-on" and so on. 32 indicates a point of time at which the prior art short-circuit detecting device described above would detect a short-circuit existing.

It is illustrated in Fig 4 how the current 21 through the power semiconductor device in question is developed over the time and how this reaches a top value and after that decreases as of the point of time 19 when the turn-off process is started. The graph 22 illustrates the development of the current at normal turn-on of the power semiconductor device, while the graph 23 illustrates how the current through the power semiconductor device would develop should the prior art method discussed in the introduction be used for detecting the short-circuit and the short-circuit be detected at the point of time 32, in which the typical current integral value to which the power semiconductor device is exerted during the short-circuit process may through the method according to the invention be a fraction of the case according to the prior art method according to the graph 23. A current-limiting level of the power semiconductor device is here also illustrated by the dashed line 34.

How a short-circuit occurring when a power semiconductor device is turned on is detected by the increase of the voltage across the electrodes of the power semiconductor device at 24 is also illustrated in Fig 3. 25 indicates a point of time for sending a turn-off order to the power semiconductor device at normal operation thereof.

It is illustrated in Fig 5 how the turn-off process according to the invention is carried out for each individual power semiconductor device independently of the rest of the power semiconductor devices. The negative turn-off current fed to the gate 9 of the power semiconductor device at normal turn-off thereof is illustrated through the dashed line 26. This current has preferably a comparatively high intensity, so that the turn-off will be fast for obtaining low turn-off losses, which however results in a comparatively high voltage overshoot which is not dramatic thanks to the comparatively low current through the power semiconductor device. However, when a short-circuit occurs it will not be possible to carry out a turn-off being just as fast, but the negative turn-off current 27 fed to the gate of the power semiconductor device has to have a lower intensity, since no high voltage overshoot may be accepted as a consequence of the comparatively high short-circuit current flowing through the power semiconductor device. The voltage across the electrodes of the individual power semiconductor device is during the very turn-off process measured all the time through the voltage divider circuit 13 and should this voltage exceed a certain level 28, the turn-off speed will be reduced by reducing the intensity of the negative current fed to the gate of the power semiconductor device. Two possible alternatives to reduce the intensity of the turn-off current are indicated in Fig 5, a stepwise one and a linear one. Should the voltage across the two electrodes of the power semiconductor device exceed the predetermined value 29, which is below the upper limit 30 of the short-circuit safe operation area of the power semiconductor device, the direction of the feeding current to the gate of the power semiconductor device will be reversed and it is turned on again so as to reduce the voltage across the electrodes thereof to an acceptable value, whereupon the turn-off may be continued. Through such an individual control of the turn-off process of each of the power semiconductor devices connected in series differences of voltages thereacross may be smoothed out and a good voltage distribution among them be obtained during the entire turn-off process, so that it may be avoided that any of the power semiconductor devices breaks down as a consequence of "avalanche" or too high heat generation wherein. It is pointed out that the voltage level 28 should be chosen so that this corresponds to the fact that the voltage across the power semiconductor device in question exceeds the average voltage across the power semiconductor devices connected in series by a certain margin, so that the turn-off process may be slowed down not before the power semiconductor device in question has a voltage thereacross clearly exceeding said average voltage. The stepwise method may be simplified and mean that it is changed to zero voltage directly at 28.

The invention is of course not in any way restricted to the preferred embodiment described above, but several possibilities to modifications thereof, except from those already mentioned above, would be apparent to a man skilled in the art without departing from the basic idea of the invention, such as this is defined in the claims.

The high voltage converter circuit shown in Fig 1 is only one conceivable application of the present invention, and many other circuits having power semiconductor devices connected in series could benefit from the present invention so as to handle short-circuit situations.

The term "short-circuit situation" is chosen to indicate that the invention relates to problems arising in the power semiconductor devices connected in series as a consequence of any short-circuit independently of where it occurs.

## Claims

1. A method for handling a short-circuit situation occurring in a circuit having a plurality of power semiconductor devices (1) of turn-off type connected in series after detection thereof, in which the voltage across both electrodes (11, 12) of each individual power semiconductor device is measured and a current is supplied to or fed away from the gate (9) of the individual power semiconductor device depending upon the magnitude of said voltage for individual regulation of the turn-off process achieved thereby for each of the power semiconductor devices depending upon said voltage thereacross, **characterized in that** the turn-off speed of each individual power semiconductor device is reduced during the turn-off process when the voltage measured thereacross increases.

2. A method according to claim 1, **characterized in that** when the voltage measured between the two electrodes of an individual power semiconductor device exceeds a predetermined value (29) it is changed to turning the power semiconductor device on by reversing the direction of said current supply to the gate (9) of this power semiconductor device with respect to the direction during turn-off.

3. A method according to claim 2, **characterized in that** when said short-circuit situation is detected during the turn-on process of an individual power semiconductor device and this by that is in current limiting mode it is during the turn-off process caused by said detection changed to turn the power semiconductor device on when the voltage exceeds a said predetermined value (29) being lower than the upper limit (30) for the short-circuit safe operating area (SCSOA) of the power semiconductor device.

4. A method according to any of claims 1-3, **characterized in that** for each individual power semiconductor device (1) a leakage current is fed from the gate with a substantially constant current intensity as long as the voltage measured across the two electrodes of the power semiconductor device is below a predetermined value (28), and when this value of the voltage is exceeded the intensity of the leakage current is reduced for a slower turn-off of the power semiconductor device.

5. A method according to claim 4, **characterized in that**, when said predetermined voltage value (28), as of which the reduction of the intensity of the leakage current is started, is exceeded, the intensity of this leakage current is reduced stepwise when determined higher voltage values are passed.

6. A method according to claim 4, **characterized in that**, when said predetermined voltage value (28), as of which the intensity of the leakage current is reduced, is exceeded, a reduction of the intensity of the leakage current being substantially linear to the rise of the voltage across the electrodes of the power semiconductor device is carried out.

7. A method according to any of claims 1-6, **characterized in that**, when a short-circuit situation of one of the power semiconductor devices is detected, said turn-off process for this individual power semiconductor device is immediately started and a signal informing about said detection is sent to an apparatus (7) in common to the power semiconductor devices, whereupon this apparatus sends signals to all the other power semiconductor devices connected in series to start turn-off processes thereof being individually regulated.

8. A device for handling a short-circuit situation occurring in a circuit having a plurality of power semiconductor devices (1) of turn-off type connected in series after detection thereof, said device comprising members (13) adapted to measure the voltage across the two electrodes (11, 12) of each individual power semiconductor device, means (8, 10) adapted to independently feed current to or from the gate (9) of each individual power semiconductor device for individually regulating the conduction thereof and members (6) adapted to receive information about said voltage and after a detection of a short-circuit control said means for individually regulating the turn-off process caused thereby for each of the power semiconductor devices, **characterized in that** said control member (6) is adapted to control the feeding means to reduce the turn-off speed for each individual power semiconductor device during the turn-off process, when the voltage measured thereacross increased.

9. A device according to claim 8, **characterized in that** it comprises members (31) adapted to compare the voltage measured across each individual power semiconductor device (1) with reference voltage values associated with the power semiconductor device and send information about this comparison to said control member (6) for individually controlling the turn-off process of each power semiconductor device.

10. A device according to claim 9, **characterized in that**, when the voltage across the two electrodes (11, 12) of an individual power semiconductor device exceeds a predetermined reference value (29), said control members (6) are adapted to control the feeding means to cause a transition to turn on of the power semiconductor device by reversing the direction of the current fed to the gate (9) of this power semiconductor device with respect to the direction at turn-off.

11. A device according to any of claims 8-10, **characterized in that** said members for measuring the voltage across the two electrodes of each individual power semiconductor device comprise a voltage divider (13) connected in parallel with the respective power semiconductor device and adapted to measure a certain proportion of said voltage for determining the real voltage.

12. A device according to claim 11, **characterized in that** said voltage divider (13) has a large band width extending from 0 Hz to a frequency region being high with respect to the typical switching frequencies of the power semiconductor device.

## Patentansprüche

1. Verfahren zum Handhaben einer Kurzschlusssituation, die in einem Schaltkreis mit mehreren in Serie geschalteten Leistungshalbleiterbauelementen (1) vom Abschaltetyp auftritt, nach einer Detektion derselben, bei dem die Spannung über beiden Elektroden (11, 12) jedes einzelnen Leistungshalbleiterbauelements gemessen wird und in Abhängigkeit von der Größe der Spannung ein Strom dem Gate (9) des einzelnen Leistungshalbleiterbauelements geliefert wird oder von diesem weggeführt wird, für eine individuelle Regelung des Abschalteprozesses, der **dadurch** für jedes der Leistungshalbleiterbauelemente in Abhängigkeit von der Spannung darüber erreicht wird,
**dadurch gekennzeichnet, dass**
die Abschaltegeschwindigkeit jedes einzelnen Leistungshalbleiterbauelements während des Abschalteprozesses reduziert wird, wenn sich die darüber gemessene Spannung erhöht.

2. Verfahren nach Anspruch 1,
**dadurch gekennzeichnet, dass**,
wenn die zwischen den beiden Elektroden eines einzelnen Leistungshalbleiterbauelements gemessene Spannung einen vorbestimmten Wert (29) übersteigt, sie durch Umkehren der Richtung der Stromzufuhr zu dem Gate (9) dieses Leistungshalbleiterbauelements in Bezug auf die Richtung während des Abschaltens geändert wird, um das Leistungshalbleiterbauelement anzuschalten.

3. Verfahren nach Anspruch 2,
**dadurch gekennzeichnet, dass**,
wenn die Kurzschlusssituation während des Anschalteprozesses eines einzelnen Leistungshalbleiterbauelements detektiert wird und sich dieses **dadurch** in einem Strombegrenzungsmodus befindet, sie während des durch die Detektion bewirkten Abschalteprozesses geändert wird, um das Leistungshalbleiterbauelement anzuschalten, wenn die Spannung einen vorbestimmten Wert (29) übersteigt, der niedriger als die obere Grenze (30) für den sicheren Betriebsbereich bei Kurzschluss (SCSOA) des Leistungshalbleiterbauelements ist.

4. Verfahren nach einem der Ansprüche 1-3,
**dadurch gekennzeichnet, dass**
für jedes einzelne Leistungshalbleiterbauelement (1) ein Reststrom von dem Gate mit einer im Wesentlichen konstanten Stromstärke zugeführt wird, solange die über den beiden Elektroden des Leistungshalbleiterbauelements gemessene Spannung unter einem vorbestimmten Wert (28) liegt, und dass, wenn dieser Wert der Spannung überstiegen wird, die Stärke des Reststroms für ein langsameres Abschalten des Leistungshalbleiterbauelements reduziert wird.

5. Verfahren nach Anspruch 4,
**dadurch gekennzeichnet, dass**,
wenn der vorbestimmte Spannungswert (28), ab dem mit der Reduzierung der Stärke des Reststroms begonnen wird, überstiegen wird, die Stärke dieses Reststroms schrittweise reduziert wird, wenn bestimmte höhere Spannungswerte überschritten werden.

6. Verfahren nach Anspruch 4,
**dadurch gekennzeichnet, dass**,
wenn der vorbestimmte Spannungswert (28), bei dem die Stärke des Reststroms reduziert wird, überstiegen wird, eine Reduzierung der Stärke des Reststroms durchgeführt wird, die im Wesentlichen linear zu dem Anstieg der Spannung über den Elektroden des Leistungshalbleiterbauelements ist.

7. Verfahren nach einem der Ansprüche 1-6,
**dadurch gekennzeichnet, dass**,
wenn eine Kurzschlusssituation eines der Leistungshalbleiterbauelemente detektiert wird, der Abschalteprozess für dieses einzelne Leistungshalbleiterbauelement sofort gestartet wird und ein Signal, das über die Detektion informiert, an eine Vorrichtung (7) gesendet wird, die den Leistungshalbleiterbauelementen gemein ist, woraufhin diese Vorrichtung Signale an alle anderen Leistungshalbleiterbauelemente sendet, die in Serie geschaltet sind, um Abschalteprozesse dieser zu starten, die individuell geregelt sind.

8. Einrichtung zum Handhaben einer Kurzschlusssituation, die in einem Schaltkreis mit mehreren in Serie geschalteten Leistungshalbleiterbauelementen (1) vom Abschaltetyp auftritt, nach einer Detektion dieser, wobei die Einrichtung Bauteile (13), die geeignet sind, um die Spannung über den beiden Elektroden (11, 12) jedes einzelnen Leistungshalbleiterbauelements zu messen, ein Mittel (8, 10), das geeignet ist, um unabhängig zu oder von dem Gate (9) jedes einzelnen Leistungshalbleiterbauelements Strom zuzuführen, um dessen Leitung zu regeln, und Bauteile (6), die geeignet sind, um eine Information über die Spannung zu empfangen und nach einer Detektion eines Kurzschlusses das Mittel zur individuellen Regelung des **dadurch** verursachten Abschaltprozesses für jedes der Leistungshalbleiterbauelemente zu steuern,
**dadurch gekennzeichnet, dass**
das Steuerbauteil (6) geeignet ist, um das Zufuhrmittel zu steuern, um für jedes einzelne Leistungshalbleiterbauelement während des Abschalteprozesses die Abschaltegeschwindigkeit zu reduzieren, wenn sich die hierüber gemessene Spannung erhöht.

9. Einrichtung nach Anspruch 8,
**dadurch gekennzeichnet, dass**
sie Bauteile (31) umfasst, die geeignet sind, um die über jedem einzelnen Leistungshalbleiterbauelement (1) gemessene Spannung mit dem Leistungshalbleiterbauelement zugehörigen Referenzspannungswerten zu vergleichen und eine Information über diesen Vergleich zum individuellen Steuern des Abschalteprozesses jedes Leistungshalbleiterbauelements an das Steuerbauteil (6) zu senden.

10. Einrichtung nach Anspruch 9,
**dadurch gekennzeichnet, dass**,
wenn die Spannung über den beiden Elektroden (11, 12) eines einzelnen Leistungshalbleiterbauelements einen vorbestimmten Referenzwert (29) übersteigt, die Steuerbauteile (6) geeignet sind, um das Zufuhrmittel zu steuern, um einen Übergang zum Anschalten des Leistungshalbleiterbauelements zu bewirken, indem die Richtung des dem Gate (9) dieses Leistungshalbleiterbauelements zugeführten Stroms in Bezug auf die Richtung beim Abschalten umgekehrt wird.

11. Einrichtung nach einem der Ansprüche 8 - 10,
**dadurch gekennzeichnet, dass**
die Bauteile zum Messen der Spannung über den beiden Elektroden jedes einzelnen Leistungshalbleiterbauelements einen Spannungsteiler (13) umfassen, der parallel zu dem jeweiligen Leistungshalbleiterbauelement geschaltet ist und geeignet ist, um zum Ermitteln der tatsächlichen Spannung einen bestimmten Anteil der Spannung zu messen.

12. Einrichtung nach Anspruch 11,
**dadurch gekennzeichnet, dass**
der Spannungsteiler (13) eine große Bandbreite aufweist, die sich von 0 Hz zu einem Frequenzbereich erstreckt, der in Bezug auf die typischen Schaltfrequenzen des Leistungshalbleiterbauelements hoch ist.

## Revendications

1. Procédé pour traiter une situation de court-circuit survenant dans un circuit ayant une pluralité de dispositifs à semi-conducteurs de puissance (1) de type à mise hors tension montés en série après la détection de celle-ci, dans lequel la tension à travers les deux électrodes (11, 12) de chaque dispositif à semi-conducteurs de puissance individuel est mesurée et un courant est délivré à la grille (9) du dispositif à semi-conducteurs de puissance individuel ou depuis celle-ci en fonction de la grandeur de ladite tension pour une régulation individuelle du processus de mise hors tension ainsi obtenu pour chacun des dispositifs à semi-conducteurs de puissance en fonction de ladite tension à travers ceux-ci, **caractérisé en ce que** la vitesse de mise hors tension de chaque dispositif à semi-conducteurs de puissance individuel est réduite pendant le processus de mise hors tension lorsque la tension mesurée à travers ceux-ci augmente.

2. Procédé selon la revendication 1, **caractérisé en ce que** lorsque la tension mesurée entre les deux électrodes d'un dispositif à semi-conducteurs de puissance individuel dépasse une valeur prédéterminée (29), elle est changée pour mettre sous tension le dispositif à semi-conducteurs de puissance en inversant la direction dudit courant délivré à la grille (9) de ce dispositif à semi-conducteurs de puissance par rapport à la direction pendant la mise hors tension.

3. Procédé selon la revendication 2, **caractérisé en ce que** lorsque ladite situation de court-circuit est détectée pendant le processus de mise sous tension d'un dispositif à semi-conducteurs de puissance individuel et que la raison de ceci est un mode de limitation de courant, c'est pendant le processus de mise hors tension provoqué par ladite détection changée pour mettre sous tension le dispositif à semi-conducteurs de puissance lorsque la tension dépasse ladite valeur prédéterminée (29) étant inférieure à la limite supérieure (30) pour la zone opérationnelle de sécurité de court-circuit (SCSOA) du dispositif à semi-conducteurs de puissance.

4. Procédé selon l'une quelconque des revendications 1 à 3, **caractérisé en ce que** pour chaque dispositif à semi-conducteurs de puissance individuel (1) un courant de fuite est délivré depuis la grille avec une intensité de courant sensiblement constante tant que la tension mesurée à travers les deux électrodes du dispositif à semi-conducteurs de puissance est au-dessous d'une valeur prédéterminée (28), et lorsque cette valeur de la tension est dépassée l'intensité du courant de fuite est réduite pour une mise hors tension plus lente du dispositif à semi-conducteurs de puissance.

5. Procédé selon la revendication 4, **caractérisé en ce que**, lorsque ladite valeur de tension prédéterminée (28), depuis laquelle la réduction de l'intensité du courant de fuite est lancée, est dépassée, l'intensité de ce courant de fuite est réduite pas-à-pas lorsque des valeurs de tension supérieure déterminées sont transmises.

6. Procédé selon la revendication 4, **caractérisé en ce que**, lorsque ladite valeur de tension prédéterminée (28), depuis laquelle l'intensité du courant de fuite est réduite, est dépassée, une réduction de l'intensité du courant de fuite étant sensiblement linéaire à l'augmentation de la tension à travers les électrodes du dispositif à semi-conducteurs de puissance est effectuée.

7. Procédé selon l'une quelconque des revendications 1 à 6, **caractérisé en ce que**, lorsqu'une situation de court-circuit de l'un des dispositifs à semi-conducteurs de puissance est détectée, ledit processus de mise hors tension pour ce dispositif à semi-conducteurs de puissance individuel est immédiatement lancé et un signal informant de ladite détection est envoyé à un dispositif (7) en commun avec les dispositifs à semi-conducteurs de puissance, après quoi ce dispositif envoie des signaux à tous les autres dispositifs à semi-conducteurs de puissance montés en série pour lancer des processus de mise hors tension de ceux-ci étant individuellement régulés.

8. Dispositif pour traiter une situation de court-circuit survenant dans un circuit ayant une pluralité de dispositifs à semi-conducteurs de puissance (1) de type à mise hors tension montés en série après la détection de celle-ci, ledit dispositif comportant des éléments (13) adaptés pour mesurer la tension à travers les deux électrodes (11, 12) de chaque dispositif à semi-conducteurs de puissance individuel, des moyens (8, 10) adaptés pour délivrer indépendamment du courant à la grille (9) de chaque dispositif à semi-conducteurs de puissance individuel ou depuis celle-ci pour réguler individuellement la conduction de ceux-ci et des éléments (6) adaptés pour recevoir des informations concernant ladite tension et après une détection d'un court-circuit commander lesdits moyens pour réguler individuellement le processus de mise hors tension ainsi provoqué pour chacun des dispositifs à semi-conducteurs de puissance, **caractérisé en ce que** ledit élément de commande (6) est adapté pour commander les moyens d'alimentation afin de réduire la vitesse de mise hors tension pour chaque dispositif à semi-conducteurs de puissance individuel pendant le processus de mise hors tension, lorsque la tension mesurée à travers ceux-ci augmente.

9. Dispositif selon la revendication 8, **caractérisé en ce qu'**il comporte des éléments (31) adaptés pour comparer la tension mesurée à travers chaque dispositif à semi-conducteurs de puissance individuel (1) à des valeurs de tension de référence associées au dispositif à semi-conducteurs de puissance et envoyer des informations concernant cette comparaison audit élément de commande (6) pour commander individuellement le processus de mise hors tension de chaque dispositif à semi-conducteurs de puissance.

10. Dispositif selon la revendication 9, **caractérisé en ce que**, lorsque la tension à travers les deux électrodes (11, 12) d'un dispositif à semi-conducteurs de puissance individuel excède une valeur de référence prédéterminée (29), lesdits éléments de commande (6) sont adaptés pour commander les moyens d'alimentation afin d'amener une transition pour mettre sous tension le dispositif à semi-conducteurs de puissance en inversant la direction du courant délivré à la grille (9) de ce dispositif à semi-conducteurs de puissance eu égard à la direction au moment de la mise hors tension.

11. Dispositif selon l'une quelconque des revendications 8 à 10, **caractérisé en ce que** lesdits éléments pour mesurer la tension à travers les deux électrodes de chaque dispositif à semi-conducteurs de puissance individuel comportent un diviseur de tension (13) monté en parallèle avec le dispositif à semi-conducteurs de puissance respectif et adapté pour mesurer une proportion particulière de ladite tension afin de déterminer la tension réelle.

12. Dispositif selon la revendication 11, **caractérisé en ce que** ledit diviseur de tension (13) a une grande largeur de bande s'étendant de 0 Hz jusqu'à une région de fréquence étant élevée eu égard aux fréquences de commutation typiques du dispositif à semi-conducteurs de puissance.
